# EUROPEAN PATENT APPLICATION

(11) **EP 0 855 622 A1**
(43) Date of publication of application: **29.07.1998**
(21) Application number: 98101210.7
(22) Date of filing: 23.01.1998
(51) Int. Cl.: G03F 7/075

(54) **Pattern formation method**

(30) Priority: 23.01.1997 JP 10012/97
(71) Applicant: MATSUSHITA ELECTRIC INDUSTRIAL CO., LTD., Kadoma-shi, Osaka 571 (JP); Shin-Etsu Chemical Co., Ltd., Chiyoda-ku Tokyo 100 (JP)
(72) Inventor: Endo, Masayuki, Izumi-shi, Osaka 594 (JP); Fukumoto, Toru, Kyoto-shi, Kyoto 612 (JP); Ohsaki, Hiromi, Joetsu-shi, Niigara 942 (JP)
(74) Representative: Grünecker, Kinkeldey, Stockmair & Schwanhäusser Anwaltssozietät

(57) **Abstract**

Within a coater not provided with a chemical filter, 4-trimethylsiloxy-3-penten-2-one is supplied as a surface treatment agent onto the surface of a semiconductor substrate of silicon, thereby making the surface of the semiconductor substrate hydrophobic so as to improve the adhesion of the semiconductor substrate. Then, within the coater, the semiconductor substrate is coated with a chemically amplified resist, thereby forming a resist film. Subsequently, the resist film is exposed by using a desired mask within an exposure machine not provided with a chemical filter. Ultimately, the exposed resist film is successively subjected to PEB and development within a developer not provided with a chemical filter, thereby forming a resist pattern.

## Description

### BACKGROUND OF THE INVENTION

The present invention relates to a pattern formation method for forming a resist pattern on a semiconductor substrate in a manufacturing process of a semiconductor device.

In accordance with improved density and integration of a semiconductor device, there are increasing demands for finer processing techniques in these days.

As means for attaining the fine processing in the lithography process, a technique for forming a resist pattern out of a chemically amplified resist utilizing generation of an acid by using, as exposing light, DUV light emitted by an excimer laser as a light source or light with a short wavelength such as EB and X-rays has recently been developed.

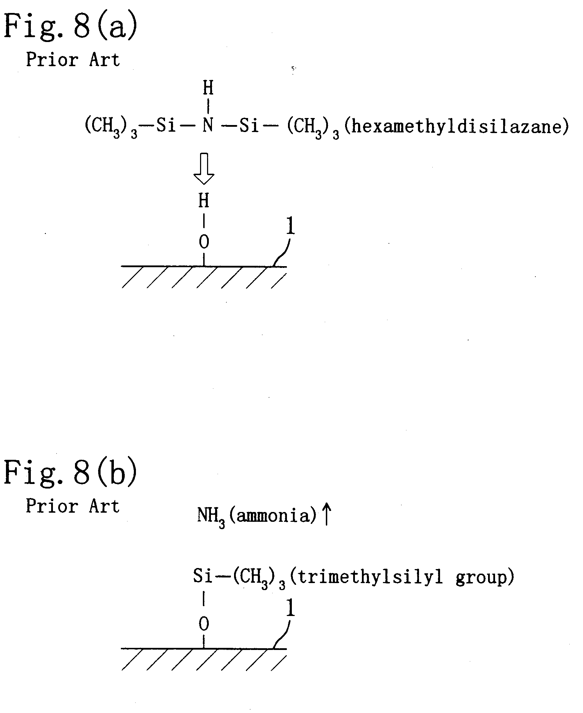

Now, a conventional pattern formation method will be described with reference to Figures 8(a) and 8(b).

First, as is shown in Figure 8(a), a surface of a semiconductor substrate 1 of silicon is supplied with hexamethyldisilazane (hereinafter referred to as HMDS) serving as a surface treatment agent, thereby making the surface of the semiconductor substrate 1 hydrophobic. Thus, the adhesion of the semiconductor substrate 1 is improved. This surface treatment is carried out by bubbling HMDS in a liquid phase with a nitrogen gas and spraying the resultant HMDS for 30 seconds onto the surface of the semiconductor substrate 1 having been heated up to 60°C. As a result, H in OH groups existing on the surface of the semiconductor substrate 1 is substituted with Si(CH₃)₃ (i.e., a trimethylsilyl group) as is shown in Figure 8(b), thereby making the surface of the semiconductor substrate 1 hydrophobic. Thus, the adhesion of the semiconductor substrate 1 is improved as well as NH₃ (ammonia) is generated.

Next, the surface of the semiconductor substrate 1 is coated with a chemically amplified resist so as to form a resist film. The resist film is exposed by using a desired mask, and is then subjected successively to post exposure bake (hereinafter refereed to as the PEB) and the development. Thus, a resist pattern is formed.

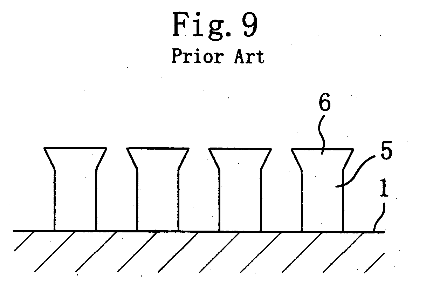

Figure 9 is a schematic sectional view of a resist pattern 5 formed in the aforementioned manner, wherein an insoluble skin layer 6 is formed on the surface of the resist pattern 5. Such an insoluble skin layer 6 formed on the surface of the resist pattern 5 can cause dimensional variation of the resist pattern 5 and etching failure in following procedures, resulting in decreasing a yield of the semiconductor device.

An alkali component is regarded as a factor in forming the insoluble skin layer 6 on the surface of the resist pattern 5. Specifically, when an alkali component exists on the surface of the resist pattern 5, an acid generated through the exposure is deactivated, resulting in forming the insoluble skin layer 6. As a result, the surface of the resist pattern 5 is formed into a T-top shape. This is understandable also in consideration of a report that a pattern cannot be resolved when a large amount of an alkali component is included (S. A. MacDonald, et al., Proc. SPIE, Vol. 1446, p. 2 (1991)).

As a countermeasure, a method of decreasing an alkali component in the air has been proposed, in which a clean room or a manufacturing apparatus such as a resist coater is provided with a chemical filter for removing an alkali component in the air (A. Saiki, et al., J. Photopolymer Sci. Technol., vol. 8, p. 599 (1995)).

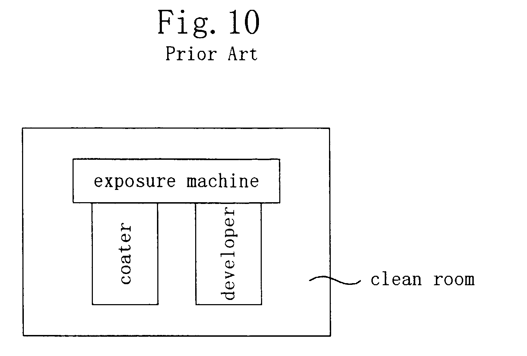

Figure 10 shows a layout in a pattern formation zone in a clean room, where a coater for coating a resist after the surface treatment of a semiconductor substrate, an exposure machine for exposing the resist film with a desired mask used and a developer for forming a resist pattern by developing the exposed resist film are successively installed.

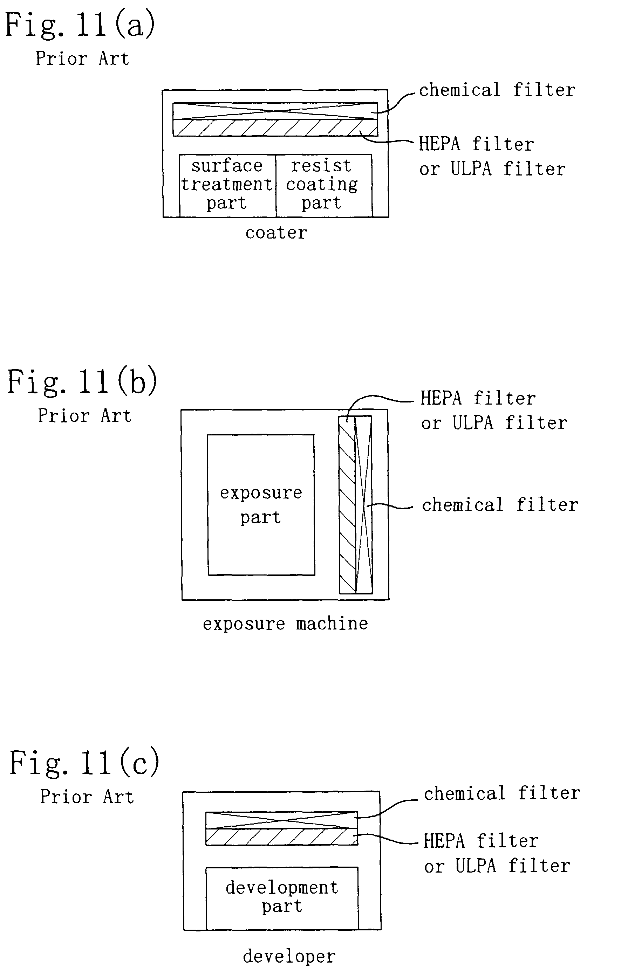

Figure 11(a) is a schematic plan view of the coater, which is provided with a surface treatment unit for conducting the surface treatment on a semiconductor substrate, a resist coating unit for coating the semiconductor substrate with a resist, a chemical filter for removing an alkali component such as ammonia in the air, and an HEPA filter or a ULPA filter for removing particles and the like in the air.

Also, Figure 11(b) is a schematic plan view of the exposure machine, which is provided with an exposing unit for conducting the exposure on the resist film with a desired mask used, a chemical filter for removing an alkali component such as ammonia in the air and an HEPA filter or a ULPA filter for removing particles and the like in the air.

Furthermore, Figure 11(c) is a schematic plan view of the developer, which is provided with a developing unit for successively conducting the PEB and the development on the exposed resist film, a chemical filter for removing an alkali component such as ammonia in the air and an HEPA filter or a ULPA filter for removing particles and the like in the air.

However, when the clean room and the manufacturing apparatuses are provided with the chemical filters, not only the cost for the semiconductor device is increased but also there arises a problem of troublesomeness in periodical exchange of the filter.

**Table 1**

| | Chemical filter | HEPA or ULPA filter |
|---|---|---|
| Object | Removal of alkali component such as ammonia | Removal of particles |
| Exchange frequency | 2 - 3 years | 10 years or more |
| Cost | one million yen per each | - |

Table 1 shows comparison between the chemical filter and the HEPA or ULPA filter. As is obvious from Table 1, the chemical filter is not only more expensive but also required to be exchanged more frequently than the HEPA or ULPA filter. In the manufacturing line for a semiconductor device, several tens coaters and exposure machines are generally installed in total. Therefore, considering that the exchange frequency of the chemical filter is 2 or 3 years, the filter exchange costs more than 10 million yens on average every year.

### SUMMARY OF THE INVENTION

In view of the aforementioned problems, the object of the invention is decreasing the number of chemical filters provided to a manufacturing line for a semiconductor device.

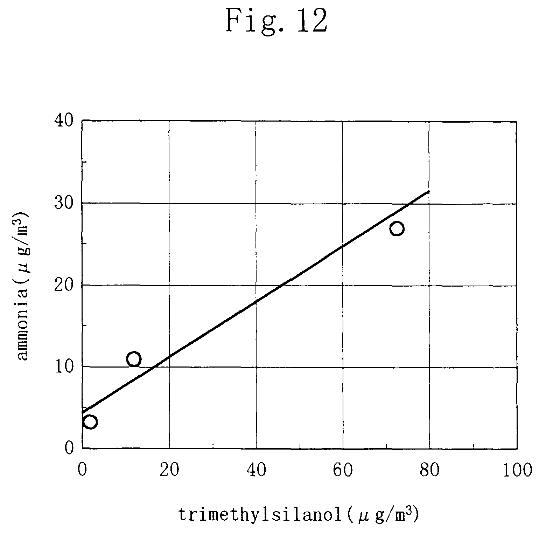

In order to find the cause of generation of an ammonia component, that is, an alkali component harmfully affecting a chemically amplified resist, the present inventors analyzed impurities included in the atmosphere in a clean room. As a result, it was found that there is positive correlation between a concentration of trimethylsilanol, that is, a decomposition of HMDS, and a concentration of ammonia in the atmosphere as is shown in Figure 12. On the basis of this finding, it is considered that an alkali component harmfully affecting the formation of a pattern of a chemically amplified resist derives from HMDS used as a surface treatment agent for a semiconductor substrate.

The present invention was devised on the basis of the aforementioned finding. By replacing conventionally used HMDS with a surface treatment agent including a silane compound represented by the general formula (1) described below, an alkali component is prevented from being generated on the surface of a semiconductor substrate. As a result, the number of chemical filters can be decreased.

The first pattern formation method of this invention comprises a resist film forming step of forming a resist film by conducting a surface treatment of a semiconductor substrate by using a surface treatment agent including a silane compound represented by the following general formula (1) in a resist coater not provided with a chemical filter for removing an alkali component in the air and by subsequently coating the surface-treated semiconductor substrate with a resist:

R¹₄₋ₙSi(OR)ₙ (1)

wherein n indicates an integer ranging between 1 and 3; R indicates a substituent or non-substituted saturated hydrocarbon group having 1 through 6 carbon atoms, a substituent or non-substituted unsaturated hydrocarbon group having 1 through 6 carbon atoms or a substituent or non-substituted alkylcarbonyl group having 1 through 6 carbon atoms; and R¹ is one group or a combination of two or more groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms and an alicyclic saturated hydrocarbon group having 3 through 6 carbon atoms; an exposing step of exposing the resist film by using a mask having a desired pattern shape; and a developing step of forming a resist pattern by developing the exposed resist film.

In the first pattern formation method, the surface of the semiconductor substrate is treated with the surface treatment agent including the silane compound represented by the general formula (1), and hence, no alkali component is generated on the surface of the semiconductor substrate through the surface treatment. Therefore, although the coater is not provided with a chemical filter, an insoluble skin layer can be prevented from being formed on the surface of the resist pattern formed on the semiconductor substrate out of a chemically amplified resist. As a result, cost increase brought by providing the coater with a chemical filter and troublesomeness due to periodical exchange of a chemical filter can be decreased.

In the first pattern formation method, the exposing step can be conducted in an exposure machine not provided with a chemical filter for removing an alkali component in the air.

Thus, even when the exposing step is conducted in an exposure machine excluding a chemical filter, no alkali component is generated in the surface treatment, and the semiconductor substrate is transferred into the exposure machine with no ammonia component attached onto the surface thereof, and hence, no ammonia component exists within the exposure machine. Accordingly, an insoluble skin layer can be prevented from being formed on the surface of the resist pattern formed on the semiconductor substrate out of a chemically amplified resist. As a result, the cost increase brought by providing the exposure machine with a chemical filter and the troublesomeness due to the periodical exchange of a chemical filter can be decreased.

In the first pattern formation method, the developing step can be conducted in a developer not provided with a chemical filter for removing an alkali component in the air.

Thus, even when the developing step is conducted in a developer excluding a chemical filter, no alkali component is generated in the surface treatment, and the semiconductor substrate is transferred into the developer with no ammonia component attached onto the surface thereof, and hence, no ammonia component exists within the developer. Accordingly, an insoluble skin layer can be prevented from being formed on the surface of the resist pattern formed on the semiconductor substrate out of a chemically amplified resist. As a result, the cost increase brought by providing the developer with a chemical filter and the troublesomeness due to the periodical exchange of a chemical filter can be decreased.

The second pattern formation method of this invention comprises a resist film forming step of forming a resist film by conducting a surface treatment on a semiconductor substrate by using a surface treatment agent including a silane compound represented by the following general formula (1) in an atmosphere not provided with a chemical filter for removing an alkali component in the air and by subsequently coating the surface-treated semiconductor substrate with a resist:

R¹₄₋ₙSi(OR)ₙ (1)

wherein n indicates an integer ranging between 1 and 3; R indicates a substituent or non-substituted saturated hydrocarbon group having 1 through 6 carbon atoms, a substituent or non-substituted unsaturated hydrocarbon group having 1 through 6 carbon atoms or a substituent or non-substituted alkylcarbonyl group having 1 through 6 carbon atoms; and R¹ is one group or a combination of two or more groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms and an alicyclic saturated hydrocarbon group having 3 through 6 carbon atoms; an exposing step of exposing the resist film by using a mask having a desired pattern shape; and a developing step of forming a resist pattern by developing the exposed resist film.

In the second pattern formation method, the atmosphere not provided with a chemical filter means that neither a coater nor a clean room accommodating the coater is provided with a chemical filter.

In the second pattern formation method, the surface of the semiconductor substrate is treated with the surface treatment agent including the silane compound represented by the general formula (1), and hence, no alkali component is generated on the surface of the semiconductor substrate through the surface treatment. Therefore, although neither the coater nor the clean room accommodating the coater is provided with a chemical filter, an insoluble skin layer can be prevented from being formed on the surface of the resist pattern formed on the semiconductor substrate out of a chemically amplified resist. As a result, the cost increase brought by providing the coater and the clean room with a chemical filter and the troublesomeness due to the periodic exchange of a chemical filter can be largely decreased.

In the second pattern formation method, the exposing step can be conducted in an atmosphere not provided with a chemical filter for removing an alkali component in the air. In this case, the atmosphere not provided with a chemical filter means that neither the exposure machine nor the clean room accommodating the exposure machine is provided with a chemical filter.

Even when the exposing step is thus conducted in the exposure machine excluding a chemical filter and installed in the clean room excluding a chemical filter for removing an alkali component in the air, the semiconductor substrate is transferred into the exposure machine with no ammonia component attached onto the surface thereof, and hence, no ammonia component exists within the exposure machine. Accordingly, an insoluble skin layer can be prevented from being formed on the surface of the resist pattern formed on the semiconductor substrate out of a chemically amplified resist. As a result, the cost increase brought by providing the exposure machine and the clean room accommodating the exposure machine with a chemical filter and the troublesomeness due to the periodic exchange of a chemical filter can be largely decreased.

In the second pattern formation method, the developing step can be conducted in an atmosphere not provided with a chemical filter for removing an alkali component in the air. In this case, the atmosphere not provided with a chemical filter means that neither the developer nor the clean room accommodating the developer is provided with a chemical filter.

Even when the developing step is thus conducted in the developer excluding a chemical filter and installed in the clean room excluding a chemical filter for removing an alkali component in the air, the semiconductor substrate is transferred into the developer with no ammonia component attached onto the surface thereof, and hence, no ammonia component exists within the developer. Accordingly, an insoluble skin layer can be prevented from being formed on the surface of the resist pattern formed on the semiconductor substrate out of a chemically amplified resist. As a result, the cost increase brought by providing the developer and the clean room accommodating the developer with a chemical filter and the troublesomeness due to the periodic exchange of a chemical filter can be largely decreased.

In the first or second pattern formation method, the silane compound used in the resist film forming step is preferably represented by the following general formula (2): 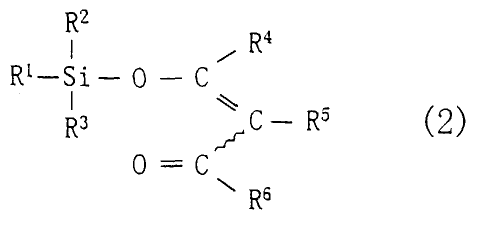 wherein R¹, R² and R³ are the same or different groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms, and an alicyclic saturated hydrocarbon group having 3 through 6 carbon atoms; and R⁴, R⁵ and R⁶ are the same or different groups selected from the group consisting of a hydrogen atom, a substituent or non-substituted saturated hydrocarbon group having 1 through 6 carbon atoms, a substituent or nonsubstituted unsaturated hydrocarbon group having 1 through 6 carbon atoms, an alicyclic saturated hydrocarbon group having 3 through 6 carbon atoms and OR⁷ (wherein R⁷ is a hydrogen atom, a substituent or non-substituted saturated hydrocarbon group having 1 through 6 carbon atoms, a substituent or non-substituted unsaturated hydrocarbon group having 1 through 6 carbon atoms, or an alicyclic saturated hydrocarbon group having 3 through 6 carbon atoms).

Specifically, in the silane compound represented by the general formula (2), the energy level of the electrophilic orbital is so low that a trimethylsilyl group included in the silane compound is highly reactive to an OH group existing on the substrate. Accordingly, a silicon atom included in the silane compound having a carbonyl group can very rapidly react to a silanol group, that is, a compound having an active hydrogen atom. Therefore, a large number of silyl groups of the silane compound are attached onto the surface of the semiconductor substrate, resulting in making the surface of the semiconductor substrate hydrophobic. Thus, the adhesion between the semiconductor substrate and a resist pattern formed thereon can be largely improved, and the resultant resist pattern can attain a good shape free from peeling.

For example, as the silane compound represented by the general formula (2), 4-trimethylsiloxy-3-penten-2-one was mixed with 0.5 equivalent of cyclohexanol, so as to measure the rate of this reaction. The obtained reaction rate was as high as 100% in 1 hour. In contrast, when the same experiment was carried out by using HMDS, that is, the conventional surface treatment agent, the reaction rate was merely 43.9% in 24 hours.

In the first or second pattern formation method, when the resist is a chemically amplified resist including an acid generator and a resin that is changed to be alkali-soluble by a function of an acid, deactivation of an acid, which is caused in using a two-component system chemically amplified positive resist, can be avoided.

In the first or second pattern formation method, when the resist is a chemically amplified resist including an acid generator, an alkali-soluble resin and a compound or resin that is changed to be alkali-soluble by a function of an acid, the deactivation of an acid, which is caused in using a three-component system chemically amplified positive resist, can be avoided.

In the first or second pattern formation method, when the resist is a chemically amplified resist including an acid generator, an alkali-soluble resin and a compound or resin that is crosslinked by a function of an acid, the deactivation of an acid, which is caused in using a three-component system chemically amplified negative resist, can be avoided.

In the first or second pattern formation method, when the resist includes a naphthoquinone diazido compound and a novolak resin, the adhesion between the semiconductor substrate and the resist pattern formed thereon can be improved in using the resist including the naphthoquinone diazido compound and the novolak resin.

### BRIEF DESCRIPTION OF THE DRAWINGS

Figures 1(a), 1(b) and 1(c) show apparatuses used in pattern formation methods according to first through third embodiments of the invention, wherein Figure 1(a) is a schematic plan view of a coater, Figure 1(b) is a schematic plan view of an exposure machine and Figure 1(c) is a schematic plan view of a developer;
Figures 2(a) and 2(b) are schematic diagrams for showing the state of a surface of a semiconductor substrate obtained by supplying 4-trimethylsiloxy-3-penten-2-one in the pattern formation method of the first embodiment;
Figure 3 is a schematic sectional view of a resist pattern formed by the pattern formation method of the first embodiment;
Figures 4(a) and 4(b) are schematic diagrams for showing the state of a surface of a semiconductor substrate obtained by supplying 4-dimethyl-n-hexylsiloxy-3-penten-2-one in the pattern formation method of the second embodiment;
Figure 5 is a schematic sectional view of a resist pattern formed by the pattern formation method of the second embodiment;
Figures 6(a) and 6(b) are schematic diagrams for showing the state of a surface of a semiconductor substrate obtained by supplying isopropenoxy trimethylsilane in the pattern formation method of the third embodiment;
Figure 7 is a schematic sectional view of a resist pattern formed by the pattern formation method of the third embodiment;
Figures 8(a) and 8(b) are schematic diagrams for showing the state of a surface of a semiconductor substrate obtained by supplying HMDS in a conventional pattern formation method;
Figure 9 is a schematic sectional view of a resist pattern formed by the conventional pattern formation method;
Figure 10 is a schematic plan view for showing a layout in a patten formation zone in a clean room;
Figure 11(a) is a schematic plan view of a conventional coater, Figure 11(b) is a schematic plan view of a conventional exposure machine and Figure 11(c) is a schematic plan view of a conventional developer; and
Figure 12 is a diagram for showing correlation between a concentration of trimethylsilanol, that is, a decomposition of HMDS, and a concentration of ammonia in the atmosphere.

### DETAILED DESCRIPTION OF THE INVENTION

### (Embodiment 1)

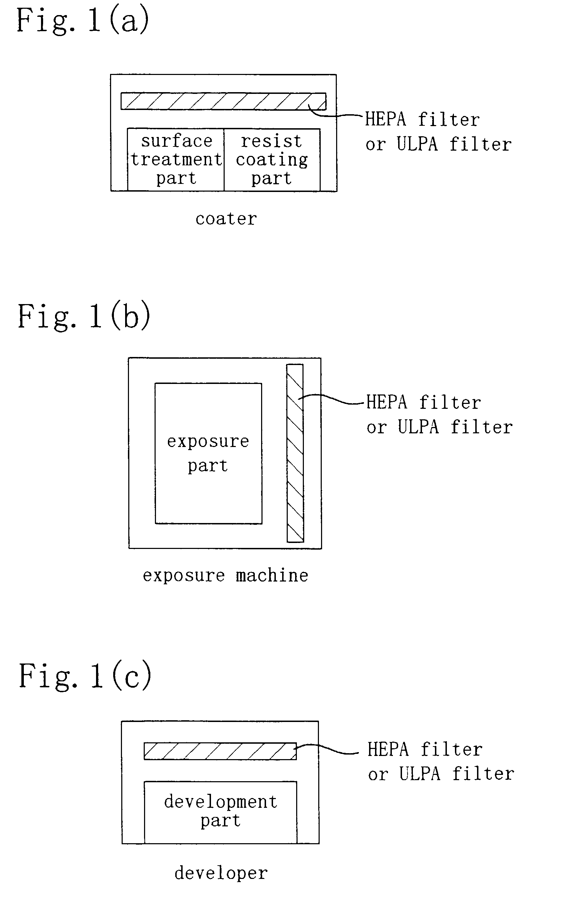

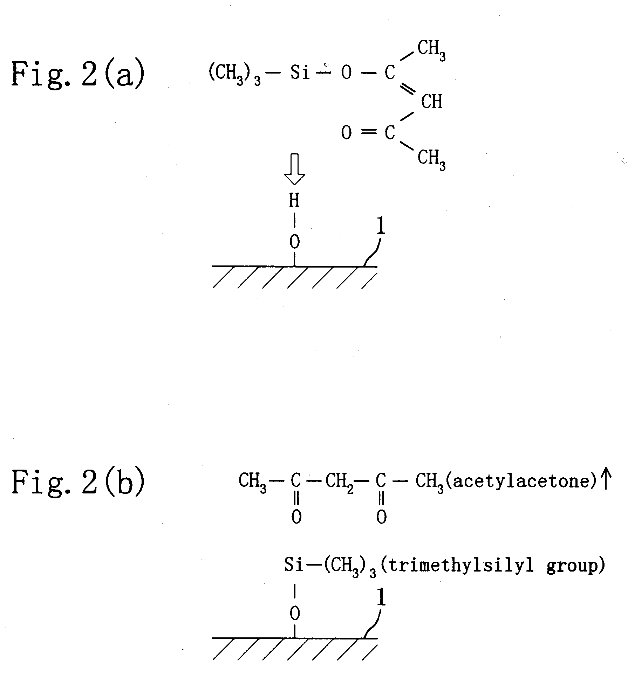

First, within a coater not provided with a chemical filter but including an HEPA filter or a ULPA filter as is shown in Figure 1(a), the surface of a semiconductor substrate 1 of silicon is supplied with 4-trimethylsiloxy-3-penten-2-one serving as a surface treatment agent as is shown in Figure 2(a). Specifically, 4-trimethylsiloxy-3-penten-2-one is bubbled with a nitrogen gas and then sprayed for 30 seconds onto the surface of the semiconductor substrate 1 having been heated up to 90°C. Thus, the surface of the semiconductor substrate 1 is made to be hydrophobic, thereby improving the adhesion of the semiconductor substrate 1.

In this manner, H in OH groups existing on the surface of the semiconductor substrate 1 is substituted with Si(CH₃)₃ (i.e., a trimethylsilyl group), resulting in producing CH₃COCH₂COCH₃ (acetylacetone) as is shown in Figure 2(b).

Then, within the coater, the semiconductor substrate 1 is coated with a chemically amplified resist, thereby forming a resist film.

Next, within an exposure machine not provided with a chemical filter but including an HEPA filter or a ULPA filter as is shown in Figure 1(b), the resist film is exposed by using a desired mask.

Subsequently, within a developer not provided with a chemical filter but including an HEPA filter or a ULPA filter as is shown in Figure 1(c), the exposed resist film is successively subjected to the PEB and the development, thereby forming a resist pattern.

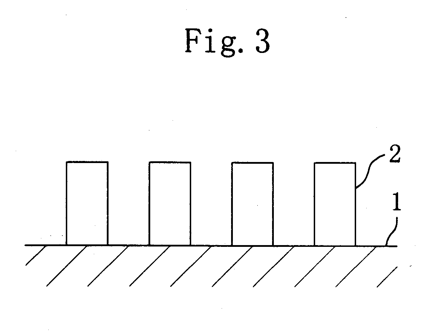

When the resist pattern is thus formed, an insoluble skin layer can be prevented from being formed on the surface of the resist pattern 2 as is shown in Figure 3. Specifically, after conducting the surface treatment with 4-trimethylsiloxy-3-penten-2-one on the semiconductor substrate 1, the semiconductor substrate 1 is coated with a chemically amplified positive resist (manufactured by Japan Synthetic Rubber Co., Ltd.; KRF K2G) in a thickness of 0.7 µm in the coater excluding a chemical filter, is exposed by using a KrF excimer laser stepper with NA of 0.5 in the exposure machine excluding a chemical filter, and is subjected to the PEB for 90 seconds at a temperature of 100°C and developed by using a 2.38 wt% aqueous solution of tetramethylammonium hydroxide in the developer excluding a chemical filter. Figure 3 shows the sectional shape of the thus formed resist pattern 2 of 0.25 µm line and space.

In this manner, since the surface treatment is conducted by using 4-trimethylsiloxy-3-penten-2-one as the surface treatment agent in this embodiment, an alkali component such as ammonia can be prevented from being produced in the surface treatment. Therefore, an insoluble skin layer can be prevented from being formed on the surface of the resist pattern 2 formed on the semiconductor substrate 1 without providing the coater with a chemical filter.

Also, since the surface treatment is conducted by using 4-trimethylsiloxy-3-penten-2-one as the surface treatment agent in this embodiment so as not to produce an alkali component such as ammonia in the surface treatment, the semiconductor substrate 1 can be subsequently transferred into the exposure machine and the developer with no ammonia component attached onto the surface thereof. Accordingly, although neither the exposure machine nor the developer is provided with a chemical filter, no ammonia component exists within the exposure machine and the developer, and therefore, an insoluble skin layer can be prevented from being formed on the surface of the resist pattern 2 formed on the semiconductor substrate 1.

As a result, it is possible to avoid cost increase brought by providing the coater, the exposure machine and the developer with a chemical filter as well as the troublesomeness caused by periodical exchange of a chemical filter.

### (Embodiment 2)

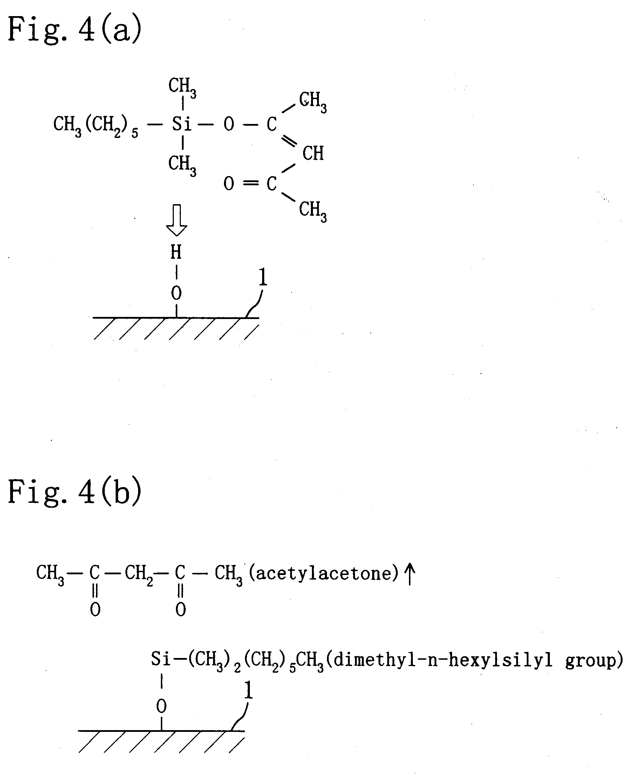

First, within a coater not provided with a chemical filter but including an HEPA filter or a ULPA filter as is shown in Figure 1(a), the surface of a semiconductor substrate 1 of silicon is supplied with 4-dimethyl-n-hexylsiloxy-3-penten-2-one serving as a surface treatment agent as is shown in Figure 4(a). Specifically, 4-dimethyl-n-hexylsiloxy-3-penten-2-one is bubbled with a nitrogen gas and then sprayed for 30 seconds onto the surface of the semiconductor substrate 1 having been heated up to 90°C. Thus, the surface of the semiconductor substrate 1 is made to be hydrophobic, thereby improving the adhesion of the semiconductor substrate 1.

In this manner, H in OH groups existing on the surface of the semiconductor substrate 1 is substituted with Si(CH₃)₂(CH₂)₅CH₃ (i.e., a dimethyl-n-hexylsilyl group), resulting in producing CH₃COCH₂COCH₃ (acetylacetone) as is shown in Figure 4(b).

Then, within the coater, the semiconductor substrate 1 is coated with a chemically amplified resist, thereby forming a resist film.

Next, within an exposure machine not provided with a chemical filter but including an HEPA filter or a ULPA filter as is shown in Figure 1(b), the resist film is exposed by using a desired mask.

Subsequently, within a developer not provided with a chemical filter but including an HEPA filter or a ULPA filter as is shown in Figure 1(c), the exposed resist film is successively subjected to the PEB and the development, thereby forming a resist pattern.

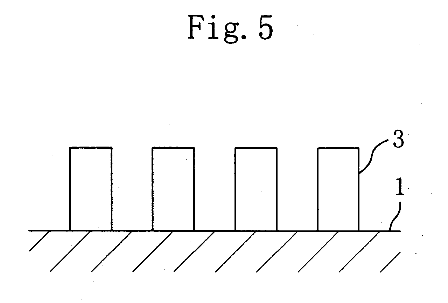

When the resist pattern is thus formed, an insoluble skin layer can be prevented from being formed on the surface of the resist pattern 3 as is shown in Figure 5. Specifically, after conducting the surface treatment with 4-dimethyl-n-hexylsiloxy-3-penten-2-one on the semiconductor substrate 1, the semiconductor substrate 1 is coated with a chemically amplified positive resist (manufactured by Japan Synthetic Rubber Co., Ltd.; KRF K2G) in a thickness of 0.7 µm in the coater excluding a chemical filter, is exposed by using a KrF excimer laser stepper with NA of 0.5 in the exposure machine excluding a chemical filter, and is subjected to the PEB for 90 seconds at a temperature of 100°C and developed by using a 2.38 wt% aqueous solution of tetramethylammonium hydroxide in the developer excluding a chemical filter. Figure 5 shows the sectional shape of the thus formed resist pattern 3 of 0.25 µm line and space.

In this manner, since the surface treatment is conducted by using 4-dimethyl-n-hexylsiloxy-3-penten-2-one as the surface treatment agent in this embodiment, an alkali component such as ammonia can be prevented from being produced in the surface treatment. Therefore, an insoluble skin layer can be prevented from being formed on the surface of the resist pattern 3 formed on the semiconductor substrate 1 without providing the coater with a chemical filter.

Also, since the surface treatment is conducted by using 4-dimethyl-n-hexylsiloxy-3-penten-2-one as the surface treatment agent in this embodiment so as not to produce an alkali component such as ammonia in the surface treatment, the semiconductor substrate 1 can be subsequently transferred into the exposure machine and the developer with no ammonia component attached onto the surface thereof. Accordingly, although neither the exposure machine nor the developer is provided with a chemical filter, no ammonia component exists within the exposure machine and the developer, and therefore, an insoluble skin layer can be prevented from being formed on the surface of the resist pattern 3 formed on the semiconductor substrate 1.

As a result, it is possible to avoid cost increase brought by providing the coater, the exposure machine and the developer with a chemical filter as well as the troublesomeness caused by periodical exchange of a chemical filter.

### (Embodiment 3)

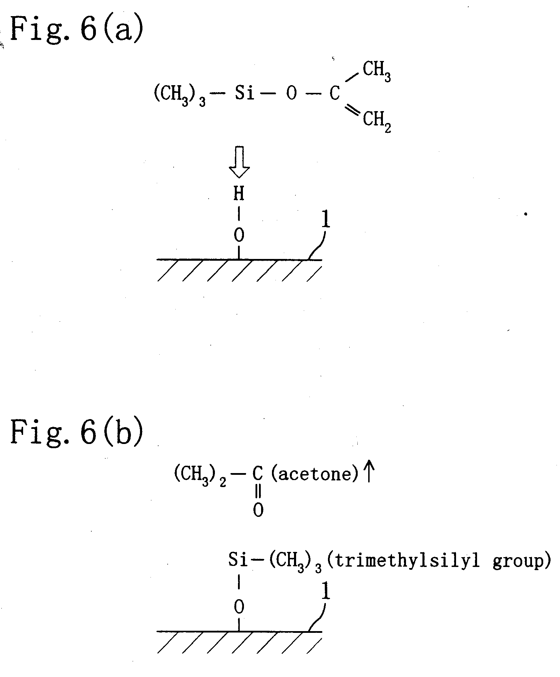

First, within a coater not provided with a chemical filter but including an HEPA filter or a ULPA filter as is shown in Figure 1(a), the surface of a semiconductor substrate 1 of silicon is supplied with isopropenoxy trimethylsilane (hereinafter referred to as IPTMS) serving as a surface treatment agent as is shown in Figure 6(a). Specifically, IPTMS is bubbled with a nitrogen gas and then sprayed for 30 seconds onto the surface of the semiconductor substrate 1 having been heated up to 90°C. Thus, the surface of the semiconductor substrate 1 is made to be hydrophobic, thereby improving the adhesion of the semiconductor substrate 1.

In this manner, H in OH groups existing on the surface of the semiconductor substrate 1 is substituted with Si(CH₃)₃ (i.e., a trimethylsilyl group), resulting in producing (CH₃)₂CO (acetone) as is shown in Figure 6(b).

Then, within the coater, the semiconductor substrate 1 is coated with a resist other than a chemically amplified resist, thereby forming a resist film.

Next, within an exposure machine not provided with a chemical filter but including an HEPA filter or a ULPA filter as is shown in Figure 1(b), the resist film is exposed by using a desired mask.

Subsequently, within a developer not provided with a chemical filter but including an HEPA filter or a ULPA filter as is shown in Figure 1(c), the exposed resist film is successively subjected to the PEB and the development, thereby forming a resist pattern.

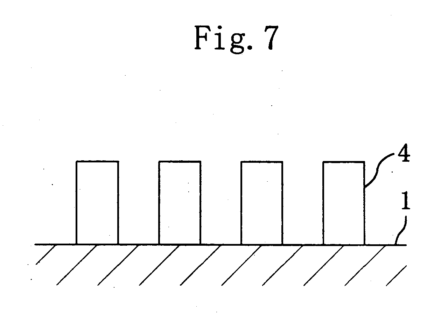

When the resist pattern 4 is thus formed, the resist pattern 4 can be formed in a good shape free from peeling as is shown in Figure 7. Specifically, after conducting the surface treatment with IPTMS on the semiconductor substrate 1, the semiconductor substrate 1 is coated with a positive resist not of a chemically amplified type (manufactured by Sumitomo Chemical Co., Ltd.; PFI-38) in a thickness of 1.0 µm in the coater excluding a chemical filter, is exposed by using an i-line stepper with NA of 0.6 in the exposure machine excluding a chemical filter, and is subjected to the PEB for 90 seconds at a temperature of 100°C and developed by using a 2.38 wt% aqueous solution of tetramethylammonium hydroxide in the developer excluding a chemical filter. Figure 7 shows the sectional shape of the thus formed resist pattern 4 of 0.30 µm line and space.

In this manner, since the surface treatment is conducted by using IPTMS as the surface treatment agent in this embodiment, an alkali component such as ammonia can be prevented from being produced in the surface treatment and the adhesion between the semiconductor substrate 1 and the resist pattern 4 can be improved. Therefore, the resultant resist pattern 4 can attain the good pattern shape free from peeling.

In each of the first through third embodiments, none of the coater, the exposure machine and the developer is provided with a chemical filter. It is noted that the present invention is first characterized by the coater excluding a chemical filter, and the exposure machine or developer excluding a chemical filter is the second characteristic.

Also, in each of the first through third embodiments, the clean room accommodating the coater, the exposure machine and the developer can be provided with a chemical filter or can exclude a chemical filter. Even when the clean room is not provided with a chemical filter, no alkali component is produced in the surface treatment of the semiconductor substrate, and hence, the amount of an ammonia component existing in the clean room is very small. Therefore, when the resist pattern is formed out of a chemically amplified resist by using the coater, the exposure machine and the developer installed in the clean room without a chemical filter, no insoluble skin layer is formed on the surface of the resist pattern.

As a result, it is possible to avoid the cost increase brought by providing the clean room with a chemical filter as well as the troublesomeness caused by periodical exchange of a chemical filter.

In the first or second embodiment, the surface treatment agent which generates a reaction decomposition including acetylacetone is used, and in the third embodiment, the surface treatment agent which generates a reaction decomposition including acetone is used. Also, in the first or third embodiment, the surface treatment agent which generates a trimethylsilyl group as a material for making the surface of the semiconductor substrate hydrophobic is used, and in the second embodiment, the surface treatment which generates a dimethyl-n-hexylsilyl group as a material for making the surface of the semiconductor substrate hydrophobic is used. However, the surface treatment agent is not limited to those described in the respective embodiments. Specifically, any surface treatment agent including a silane compound represented by the following general formula (1) is widely applicable:

R¹₄₋ₙSi(OR)ₙ (1)

wherein n indicates an integer ranging between 1 and 3; R indicates a substituent or non-substituted saturated hydrocarbon group having 1 through 6 carbon atoms, a substituent or non-substituted unsaturated hydrocarbon group having 1 through 6 carbon atoms or a substituent or non-substituted alkylcarbonyl group having 1 through 6 carbon atoms; and R¹ is one group or a combination of two or more groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms and an alicyclic saturated hydrocarbon group having 3 through 6 carbon atoms.

A first example of the silane compound represented by the general formula (1) is a compound represented by the following general formula (3):

R¹₃SiOR (3)

wherein R and R¹ are defined in the same manner as in the general formula (1).

The silane compound represented by the general formula (3) includes one hydrolytic group on the Si atom, and this compound treats the surface of a semiconductor substrate to be a monomolecular film, thereby providing a film with high surface uniformity. Also, the silane compound represented by the general formula (3) is easily affected by steric hindrance of the R¹ substituent group, and this characteristic affects the reaction speed (treatment ability).

Specific examples of the silane compound represented by the general formula (3) include the following compounds: 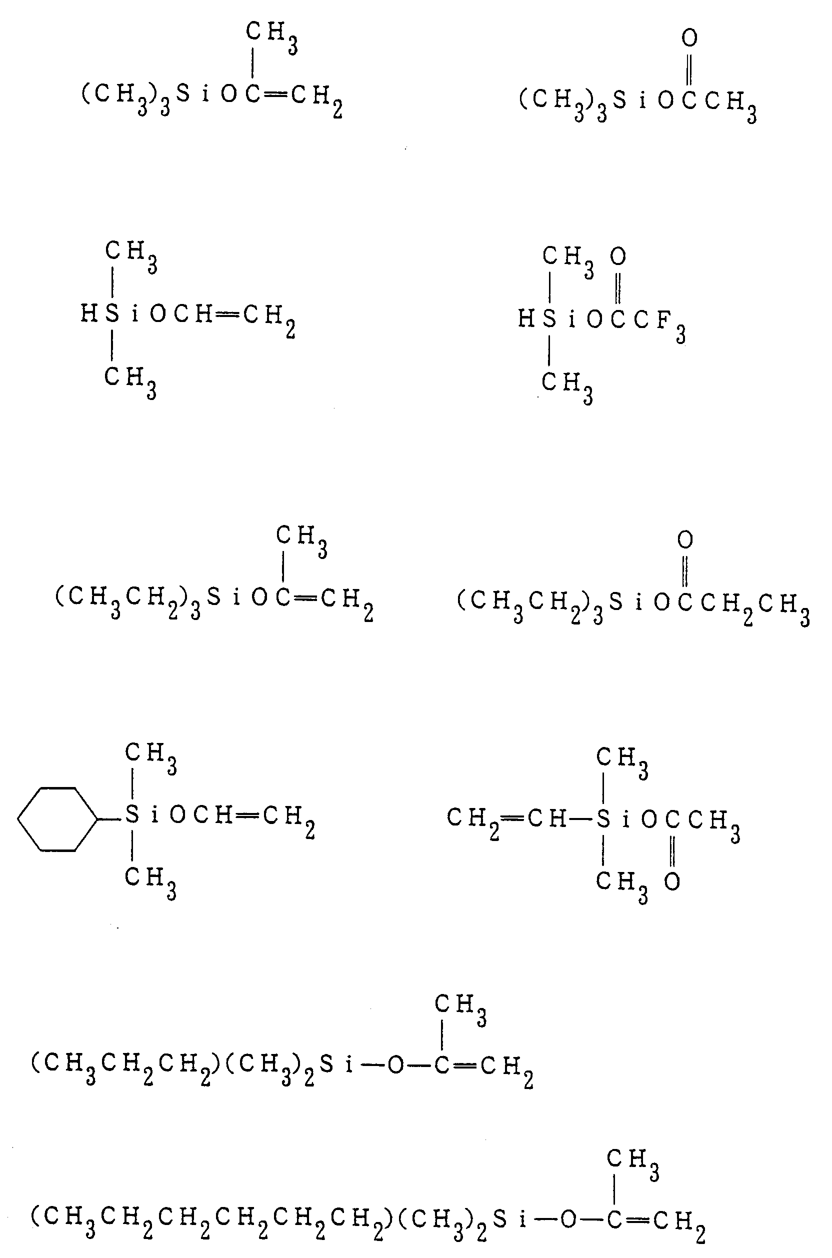 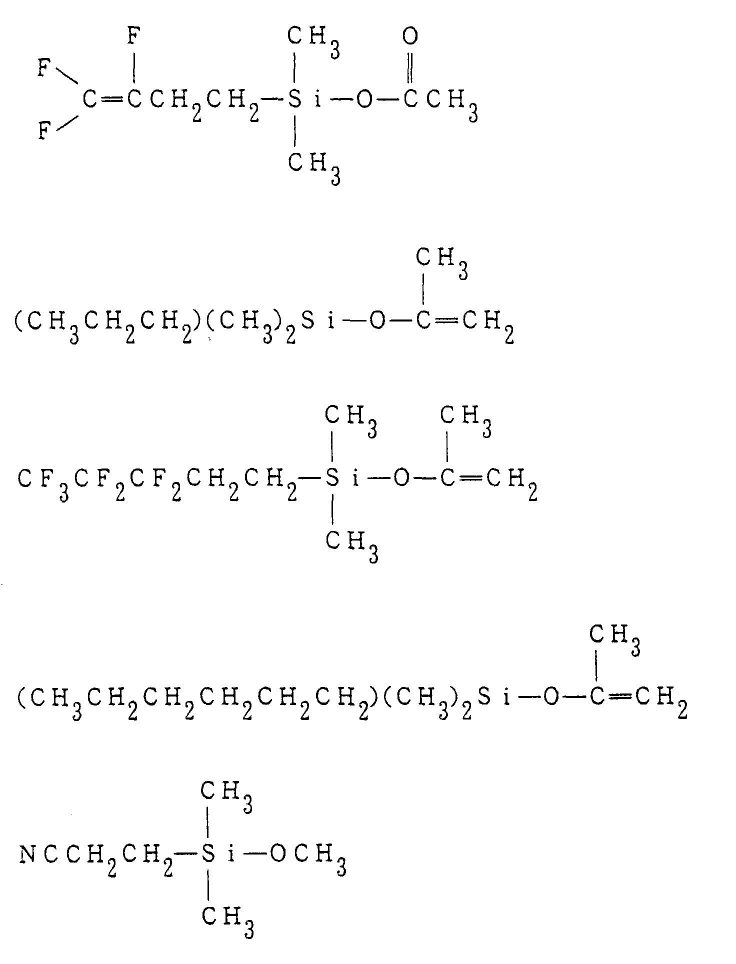 (CH₃)₃SiO-CH₃ (CH₃)₃SiOCH₂CF₃
(CH₃)₃SiO-CH₂CH₃

A second example of the silane compound represented by the general formula (1) is a compound represented by the following general formula (4):

R¹₂Si(OR)₂ (4)

wherein R¹ and R are defined in the same manner as in the general formula (1).

The silane compound represented by the general formula (4) includes two hydrolytic groups on the Si atom, and this compound treats the surface of a semiconductor substrate to be a laminate film and has a high treatment ability.

A specific example of the silane compound represented by the general formula (4) includes the following compound:
(CH₃)₂Si(OCH₂CF₃)₂ 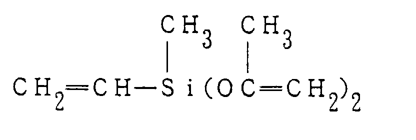 (CH₃)₂Si(OCH₃)₂ (CH₃CH₂)₂Si(OCH₂CH₃)₂ 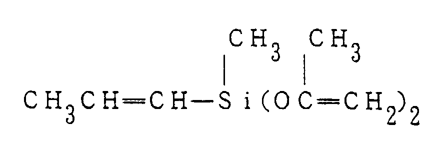 (CH₃CH₂CH₂)₂Si(OCH₃)₂

A third example of the silane compound represented by the general formula (1) is a compound represented by the following general formula (5):

R¹Si(OR)₃ (5)

wherein R and R¹ are defined in the same manner as in the general formula (1).

The silane compound represented by the general formula (5) includes three hydrolytic groups on the Si atom, treats the surface of a semiconductor substrate to be a laminate film, and has a high treatment ability. However, an unreacted part of the silane compound can be hydrolyzed by a water component in the air, so as to produce gel. Therefore, when this compound is used in the surface treatment agent, particle contamination can be caused depending upon the adopted treating method.

A specific example of the silane compound represented by the general formula (5) includes the following compound:
CH₃Si(OCH₃)₃ CH₃Si(OCH₂CH₃)₃ 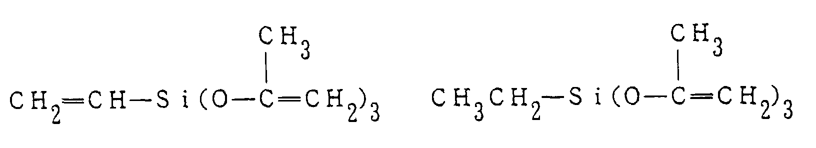 CH₃CH₂CH₂CH₂CH₂CH₂Si(OCH₃)₃

The silane compound represented by the general formula (3) has particularly high stability as a material, and the silane compound represented by the general formula (5) has particularly high reactivity.

Furthermore, any surface treatment agent including a silane compound represented by the following general formula (2) is adoptable: 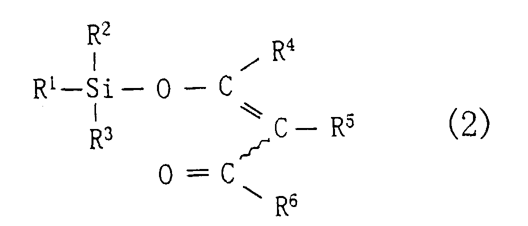 wherein R¹, R² and R³ are the same or different groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms, and an alicyclic saturated hydrocarbon group having 3 through 6 carbon atoms; and R⁴, R⁵ and R⁶ are the same or different groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms, an alicyclic saturated hydrocarbon group having 3 through 6 carbon atoms and OR⁷ (wherein R⁷ is a hydrogen atom, a substituent or non-substituted saturated hydrocarbon group having 1 through 6 carbon atoms, a substituent or non-substituted unsaturated hydrocarbon group having 1 through 6 carbon atoms, or an alicyclic saturated hydrocarbon group having 3 through 6 carbon atoms).

Specific examples of the silane compound represented by the general formula (2) include the following compounds:

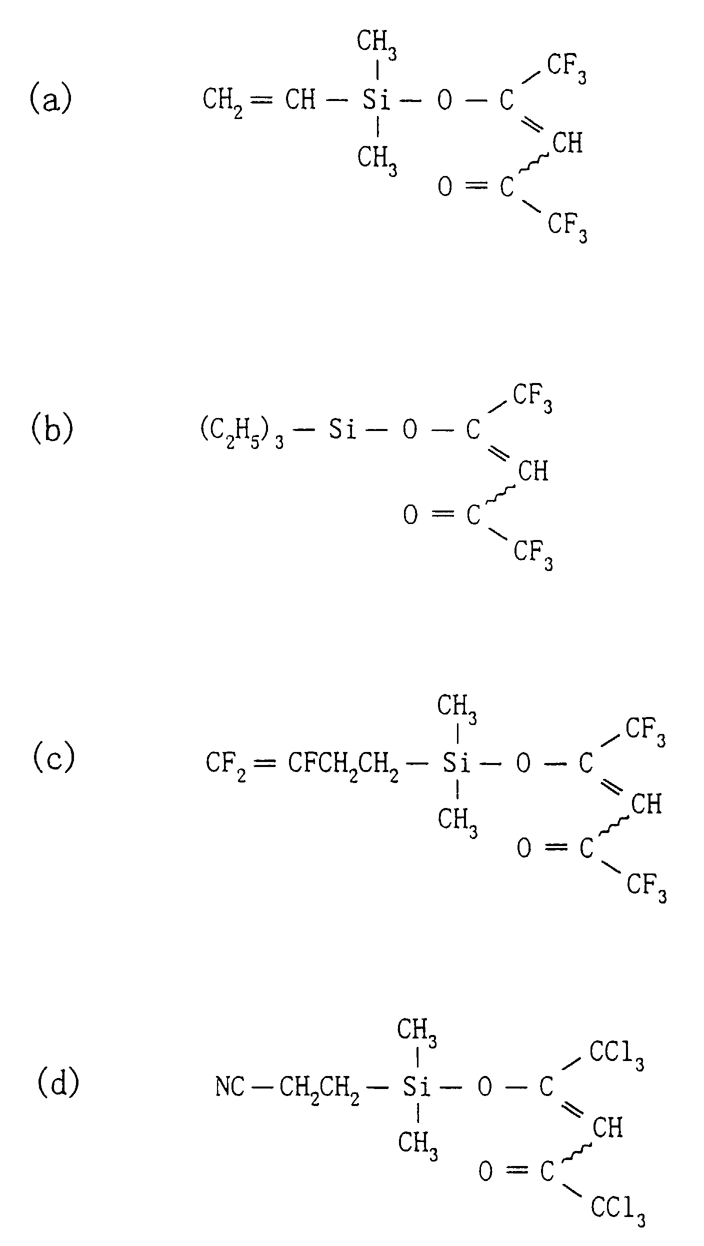

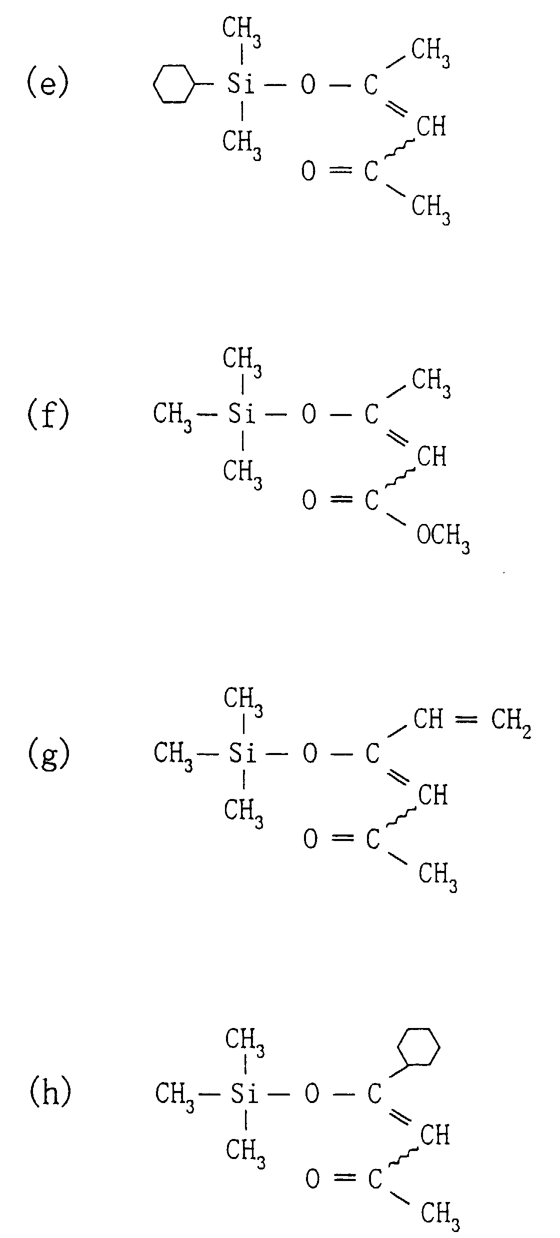

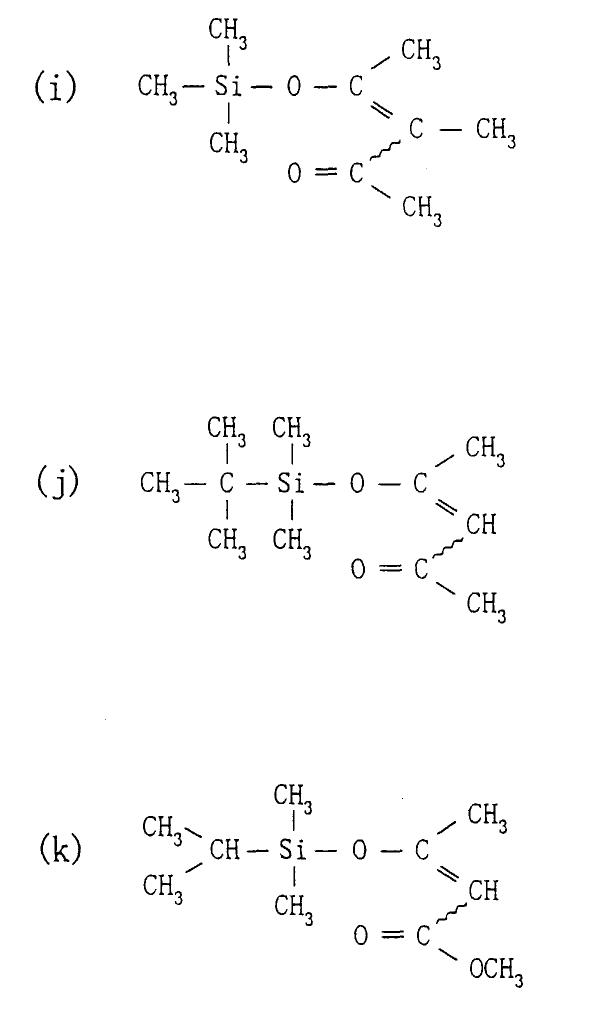

In the above-described chemical formulas, (a) indicates 3-dimethylvinylsiloxytrifluoromethyl-2-propen-1-trifluoromethyl-1-one; (b) indicates 3-triethylsiloxytrifluoromethyl-2-propen-1-trifluoromethyl-1-one; (c) indicates 3-dimethyl(3',4',4'-tr ifluoro-3'-butenyl)siloxytrifluoromethyl-2-propen-1-trifluoromethyl-1-one; (d) indicates 3-dimethyl(2'-cyanoethyl)siloxytrichloromethyl-2-propen-1-trichloromethyl-1-one; (e) indicates 4-dimethylcyclohexylsiloxy-3-penten-2-one; (f) indicates 2-trimethylsiloxy-1-methoxycarbonyl-1-propene; (g) indicates 4-trimethylsiloxy-3,5-hexadien-2-one; (h) indicates 4-trimethylsiloxy-4-cyclohexyl-3-buten-2-one; (i) indicates 4-trimethylsiloxy-3-methyl-3-penten-2-one; (j) indicates 4-t-butyldimethylsiloxy-3-penten-2-one; and (k) indicates 2-isopropyldimethylsiloxy-1-methoxycarbonyl-1-propene.

In the second and third embodiments, the two-component system chemically amplified positive resist (KRF K2G) including an acid generator and a resin that is changed to be alkali-soluble by a function of an acid is used as the chemically amplified resist. However, this chemically amplified positive resist can be replaced with a three-component system chemically amplified positive resist including an acid generator, an alkali-soluble resin and a compound or a resin that is changed to be alkali-soluble by a function of an acid. Another example of the commercially available two-component system chemically amplified positive resist includes TDUR-DP007 manufactured by Tokyo Ohka Kogyo Co., Ltd., and examples of the commercially available three-component system chemically amplified positive resist include DX561 and DX981 manufactured by Hoechst Japan Ltd.

Moreover, as the chemically amplified resist, a three-component system chemically amplified negative resist including an acid generator, an alkali-soluble resin and a compound or a resin that is crosslinked by a function of an acid can also be used. Examples of the three-component system chemically amplified negative resist include XP-8843 and SAL-601 manufactured by Shipley Company. Also in the application of such a chemically amplified negative resist, when an alkali component is produced in the surface treatment, the film thickness of the resist pattern can be decreased owing to the deactivation of an acid, resulting in degrading the shape of the resultant resist pattern. However, since the deactivation of an acid can be avoided in the present invention, the resultant resist pattern can attain a good shape owing to the method of this invention.

Since the chemically amplified resist is affected by an alkali component regardless of its composition or components, the first and second embodiments are applicable to all types of chemically amplified resists.

Examples of the components of the chemically amplified resists will now be described, and it is noted that these exemplified components do not limit the invention.

### 〈Two-component system chemically amplified positive resist〉

- Resin that is changed to be alkali-soluble by a function of an acid:
   poly(t-butoxycarbonyloxystyrene-co-hydroxystyrene)
   poly(t-butoxycarbonylmethyloxystyrene-co-hydroxystyrene)
   poly(tetrahydropyranyloxystyrene-co-hydroxystyrene)
- Acid generator:
   Onium salt, nitrobenzyl sulfonate

### 〈Three-component system chemically amplified positive resist〉

- Alkali-soluble resin:
   polyvinylphenol, polymethacrylic acid
- Resin or compound that is changed to be alkali-soluble by a function of an acid:
   poly(t-butoxycarbonyloxystyrene-co-hydroxystyrene)
   poly(t-butoxycarbonylmethyloxystyrene-co-hydroxystyrene)
   poly(tetrahydropyranyloxystyrene-co-hydroxystyrene) 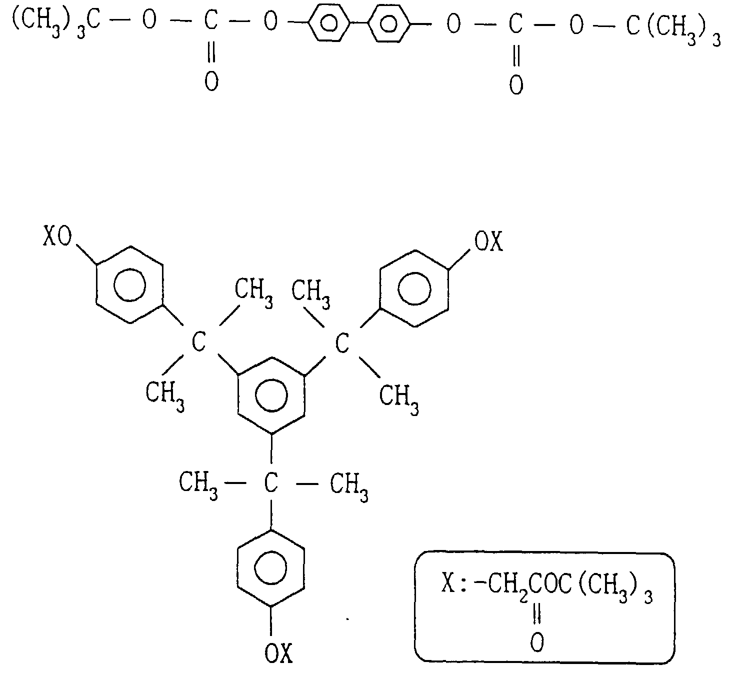
- Acid generator:
   Onium salt, nitrobenzyl sulfonate

### 〈Three-component system chemically amplified negative resist〉

- Alkali-soluble resin:
   polyvinylphenol, polymethacrylic acid
- Compound or resin that is crosslinked by a function of an acid:
   melamine compound, melamine resin
- Acid generator:
   Onium salt, nitrobenzyl sulfonate

## Claims

1. A pattern formation method comprising:
a resist film forming step of forming a resist film by conducting a surface treatment of a semiconductor substrate by using a surface treatment agent including a silane compound represented by the following general formula (1) in a resist coater not provided with a chemical filter for removing an alkali component in the air and by subsequently coating said surface-treated semiconductor substrate with a resist:
R¹₄₋ₙSi(OR)ₙ (1)
wherein n indicates an integer ranging between 1 and 3; R indicates a substituent or non-substituted saturated hydrocarbon group having 1 through 6 carbon atoms, a substituent or non-substituted unsaturated hydrocarbon group having 1 through 6 carbon atoms or a substituent or non-substituted alkylcarbonyl group having 1 through 6 carbon atoms; and R¹ is one group or a combination of two or more groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms and an alicyclic saturated hydrocarbon group having 3 through 6 carbon atoms;
an exposing step of exposing said resist film by using a mask having a desired pattern shape; and
a developing step of forming a resist pattern by developing said exposed resist film.

2. The pattern formation method of Claim 1,
wherein said exposing step is conducted in an exposure machine not provided with a chemical filter for removing an alkali component in the air.

3. The pattern formation method of Claim 1,
wherein said developing step is conducted in a developer not provided with a chemical filter for removing an alkali component in the air.

4. The pattern formation method of Claim 1,
wherein said silane compound used in said resist film forming step is represented by the following general formula (2): 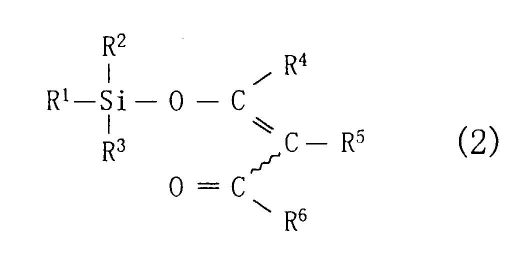 wherein R¹, R² and R³ are the same or different groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms, and an alicyclic saturated hydrocarbon group having 3 through 6 carbon atoms; and R⁴, R⁵ and R⁶ are the same or different groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms, an alicyclic saturated hydrocarbon group having 3 through 6 carbon atoms and OR⁷ (wherein R⁷ is a hydrogen atom, a substituent or non-substituted saturated hydrocarbon group having 1 through 6 carbon atoms, a substituent or non-substituted unsaturated hydrocarbon group having 1 through 6 carbon atoms, or an alicyclic saturated hydrocarbon group having 3 through 6 carbon atoms).

5. The pattern formation method of Claim 1,
wherein said resist used in said resist film forming step includes an acid generator and a resin that is changed to be alkali-soluble by a function of an acid.

6. The pattern formation method of Claim 1,
wherein said resist used in said resist film forming step includes an acid generator, an alkali-soluble resin, and a compound or resin that is changed to be alkali-soluble by a function of an acid.

7. The pattern formation method of Claim 1,
wherein said resist used in said resist film forming step includes an acid generator, an alkali-soluble resin, and a compound or resin that is crosslinked by a function of an acid.

8. The pattern formation method of Claim 1,
wherein said resist used in said resist film forming step includes a naphthoquinone diazido compound and a novolak resin.

9. A pattern formation method comprising:
a resist film forming step of forming a resist film by conducting a surface treatment on a semiconductor substrate by using a surface treatment agent including a silane compound represented by the following general formula (1) in an atmosphere not provided with a chemical filter for removing an alkali component in the air and by subsequently coating said surface-treated semiconductor substrate with a resist;
R¹₄₋ₙSi(OR)ₙ (1)
wherein n indicates an integer ranging between 1 and 3; R indicates a substituent or non-substituted saturated hydrocarbon group having 1 through 6 carbon atoms, a substituent or non-substituted unsaturated hydrocarbon group having 1 through 6 carbon atoms or a substituent or non-substituted alkylcarbonyl group having 1 through 6 carbon atoms; and R¹ is one group or a combination of two or more groups selected from the group consisting of a hydrogen atom, a substituent or non-substituted saturated hydrocarbon group having 1 through 6 carbon atoms, a substituent or non-substituted unsaturated hydrocarbon group having 1 through 6 carbon atoms and an alicyclic saturated hydrocarbon group having 3 through 6 carbon atoms;
an exposing step of exposing said resist film by using a mask having a desired pattern shape; and
a developing step of forming a resist pattern by developing said exposed resist film.

10. The pattern formation method of Claim 9,
wherein said exposing step is conducted in an atmosphere not provided with a chemical filter for removing an alkali component in the air.

11. The pattern formation method of Claim 9,
wherein said developing step is conducted in an atmosphere not provided with a chemical filter for removing an alkali component in the air.

12. The pattern formation method of Claim 9,
wherein said resist used in said resist film forming step includes an acid generator and a resin that is changed to be alkali-soluble by a function of an acid.

13. The pattern formation method of Claim 9,
wherein said resist used in said resist film forming step includes an acid generator, an alkali-soluble resin, and a compound or resin that is changed to be alkali-soluble by a function of an acid.

14. The pattern formation method of Claim 9,
wherein said resist used in said resist film forming step includes an acid generator, an alkali-soluble resin, and a compound or resin that is crosslinked by a function of an acid.

15. The pattern formation method of Claim 9,
wherein said resist used in said resist film forming step includes a naphthoquinone diazido compound and a novolak resin.
